# EUROPÄISCHE PATENTSCHRIFT

(11) **EP 4 476 801 B1**
(45) Veröffentlichungstag und Bekanntmachung des Hinweises auf die Patenterteilung: **14.01.2026**
(21) Anmeldenummer: 23703197.6
(22) Anmeldetag: 02.02.2023
(51) Int. Cl.: H02B 1/28, H02G 3/08, H05K 5/06, H02G 3/14

(54) **EXPLOSIONSGESCHÜTZTES GEHÄUSE MIT VERSTÄRKUNGSANORDNUNG**
EXPLOSION-PROOF HOUSING WITH REINFORCEMENT DEVICE
BOÎTIER ANTI-DÉFLAGRANT AVEC DISPOSITIF DE RENFORCEMENT

(30) Priorität: 07.02.2022 DE 102022102793
(43) Veröffentlichungstag der Anmeldung: 18.12.2024
(73) Patentinhaber: R. STAHL Schaltgeräte GmbH, 74638 Waldenburg (DE)
(72) Erfinder: WOLPERT, Kai-Uwe, 74238 Krautheim (DE)
(74) Vertreter: Rüger Abel Patentanwälte PartGmbB
(86) Internationale Anmeldenummer: PCT/EP2023/052554
(87) Internationale Veröffentlichungsnummer: WO 2023/148262

(56) Entgegenhaltungen:
- DE-A1- 102012 111 393
- DE-A1- 102019 131 195
- DE-A1- 3 522 778
- US-A- 4 620 061

## Beschreibung

Die Erfindung betrifft ein explosionsgeschütztes Gehäuse für den Einsatz in explosiven Umgebungen. Das explosionsgeschützte Gehäuse hat einen Innenraum, der explosionsgeschützt gegenüber der Umgebung umschlossen ist. Im Innenraum können mögliche Zündquellen angeordnet werden, die zu einer Zündung einer explosionsgefährdeten Atmosphäre in der Umgebung führen könnten. Solche Zündquellen können beispielsweise elektrische und/oder elektronische Einrichtungen bzw. Betriebsmittel sein. Das explosionsgeschützte Gehäuse ist dazu eingerichtet, ein Zünden der explosionsgefährdeten Atmosphäre in der Umgebung des Gehäuses außerhalb des Innenraums selbst dann zu verhindern, wenn im Innenraum Flammen, heiße Gase, Funken, Lichtbögen oder dergleichen entstehen.

DE 10 2012 111 393 A1 beschreibt ein explosionsgeschützte Gehäuse gemäß dem Oberbegriff des Patentanspruches 1. Es weist zwei Gehäuseteile aus Kunststoff auf, die mittels zwei Reibschweißnähten miteinander verbunden sind. DE 10 2019 131195 A1, DE 35 22 778 A1 und US 4 620 061 A beschreiben weitere explosionsgeschützte Gehäuse.

Die Reibschweißnähte unterliegen einer hohen Belastung, sollte im Innenraum des Gehäuses eine Explosion stattfinden. Das Gehäuse muss den Explosionsdruck standhalten, um zu verhindern, dass zündfähige Medien, wie heiße Gase, Funken, Flammen oder dergleichen in die explosionsgefährdete Atmosphäre der Umgebung gelangen. Solche Gehäuse dürfen in explosionsgefährdete Umgebungen nur eingesetzt werden, wenn sie normierte Prüfbedingungen erfüllen und damit eine ausreichende Sicherheit gewährleisten. Die Prüfbedingungen sind in der Norm IEC 60079-1 definiert. Beispielsweise müssen Gehäuse mit einem bestimmten Innenvolumen einem Innendruck in einem Bereich von etwa 1000 kPa bis 2000 kPa für mindestens 10 Sekunden standhalten.

Gerade bei Kunststoffgehäusen hat sich gezeigt, dass aufgrund von Schwankungen im Herstellungsprozess eine wesentlich stabilere konstruktive Ausgestaltung des Kunststoffgehäuses notwendig ist, um die Prüfbedingungen sicher zu erfüllen. Dies führt aber wiederum zu einem hohen Materialaufwand und damit hohen Kosten, beispielsweise durch größere Wandstärken des Kunststoffgehäuses. Aus Kostengründen und zur Ressourcenschonung ist dies allerdings unerwünscht.

Es kann daher als Aufgabe der vorliegenden Erfindung angesehen werden, ein nicht metallisches explosionsgeschütztes Gehäuse zu schaffen, das sich mit geringem Materialaufwand einfach herstellen lässt und das Einhalten der normierten Prüfbedingungen sicherstellt.

Diese Aufgabe wird durch ein explosionsgeschütztes Gehäuse mit den Merkmalen des Patentanspruches 1 gelöst.

Das erfindungsgemäße explosionsgeschützte Gehäuse weist ein nicht metallisches erstes Gehäuseteil und ein nicht metallisches zweites Gehäuseteil auf. Die beiden Gehäuseteile bestehen vorzugsweise aus Kunststoff oder einem Verbundwerkstoff aufweisend eine Kunststoffmatrix, in die Verstärkungselemete bzw. Verstärkungsfasern eingebettet sind. Der Verbundwerkstoff kann beispielsweise Verstärkungsfasern aus Glas und/oder Kohlenstoff enthalten. Als Kunststoff für die Gehäuseteile oder für die Matrix der aus Verbundwerkstoff bestehenden Gehäuseteile wird insbesondere ein Thermoplast verwendet.

Das erste Gehäuseteil umgibt einen ersten Innenraum, der über eine erste Gehäuseöffnung zugänglich ist. Die erste Gehäuseöffnung wird in einer Umfangsrichtung von einem ersten Flansch vollständig umschlossen. An dem ersten Flansch ist eine erste Verbindungsfläche vorhanden, die die erste Gehäuseöffnung in Umfangsrichtung vollständig umschließt.

Das zweite Gehäuseteil ist analog zum ersten Gehäuseteil aufgebaut. Es umgibt einen zweiten Innenraum, der über eine zweite Gehäuseöffnung zugänglich ist. Die zweite Gehäuseöffnung wird in der Umfangsrichtung von einem zweiten Flansch vollständig umschlossen. An dem zweiten Flansch ist eine zweite Verbindungsfläche vorhanden, die die zweite Gehäuseöffnung in Umfangsrichtung vollständig umschließt.

Mittels der beiden Verbindungsflächen können die beiden Gehäuseteile stoffschlüssig und/oder durch eine Haftvermittlung miteinander verbunden werden. Bei hergestellter Verbindung liegen sich die beiden Verbindungsflächen gegenüber. Sie können unmittelbar stoffschlüssig miteinander verbunden sein, beispielsweise durch Herstellen einer Schweißverbindung, wie etwa einer Laserschweißverbindung, einer Ultraschallschweißverbindung oder einer Reibschweißverbindung. Zusätzlich oder alternativ kann zwischen den Verbindungsflächen bzw. zumindest zwischen einem jeweiligen Abschnitt der ersten Verbindungsfläche und der zweiten Verbindungsfläche eine Haftvermittlungsschicht vorhanden sein.

Die stoffschlüssige und/oder durch eine Haftvermittlung hergestellte Verbindung zwischen dem ersten Gehäuseteil und dem zweiten Gehäuseteil ist vorzugsweise fluiddicht.

Zur Verstärkung und/oder Versteifung weist jedes Gehäuseteil benachbart zu der betreffenden Verbindungsfläche und außerhalb des jeweiligen Innenraums wenigstens einen Verstärkungsvorsprung auf. Der Verstärkungsvorsprung erstreckt sich in Umfangsrichtung vorzugsweise nur teilweise um die jeweilige Gehäuseöffnung. Im Falle einer polygonalen Gehäuseöffnung erstreckt sich der Verstärkungsvorsprung zumindest entlang eines Abschnitts einer Seite und vorzugsweise nicht kontinuierlich über mehrere Seiten.

Der Verstärkungsvorsprung ist bei einer bevorzugten Ausführungsform jeweils integral bzw. monolithisch mit dem betreffenden Gehäuseteil ausgebildet.

Der Verstärkungsvorsprung kann eine leistenartige Gestalt aufweisen. Er ragt insbesondere von dem jeweiligen Gehäuseteil schräg oder rechtwinklig nach außen weg. Bei einer hergestellten Verbindung zwischen dem ersten Gehäuseteil und dem zweiten Gehäuseteil kann jeder Verstärkungsvorsprung des ersten Gehäuseteils an einem Verstärkungsvorsprung des zweiten Gehäuseteils anliegen oder mit Abstand gegenüberliegend angeordnet sein.

Vorzugsweise ist jeder Verstärkungsvorsprung nicht massiv ausgeführt, sondern weist mehrere Hohlräume auf, die beispielsweise durch eine gitterartige Struktur gebildet sein können. Die Hohlräume können zumindest an einer Seite des Verstärkungsvorsprungs offen sein, beispielsweise auf der dem jeweils anderen Gehäuseteil abgewandten Seite.

Jeder Verstärkungsvorsprung hat jeweils ein daran angebrachtes und vorzugsweise lösbar angebrachtes metallisches Verstärkungselement, die zu einer gemeinsamen Verstärkungsanordnung gehören. In Umfangsrichtung kann die Länge des metallischen Verstärkungselements im Wesentlichen der Länge des Verstärkungsvorsprungs entsprechen, wobei die Länge des an einem Verstärkungsvorsprung angebrachten Verstärkungselements mindestens 80% oder mindestens 90% oder mindestens 95% der Länge des Verstärkungsvorsprungs entsprechen kann.

Durch die wenigstens eine zusätzliche Verstärkungsanordnung aus jeweils einem Verstärkungsvorsprung und jeweils einem daran angebrachten metallischen Verstärkungselement sind die Gehäuseteile zusätzlich seitlich verstärkt bzw. versteift. Bei im Wesentlichen quaderförmigen Gehäuseteilen oder anderen polygonalen Gehäuseteilen ist es vorteilhaft, an jeder Seite eine Verstärkungsanordnung anzubringen, die eine Mindestlänge übersteigt. Die Mindestlänge kann beispielsweise 10 cm oder 15 cm oder 20 cm betragen.

Durch ein derart verstärktes Gehäuseteil kann das explosionsgeschützte Gehäuse auch bei vergleichsweise geringen Wandstärken dem erforderlichen Prüfdruck bzw. dem Explosionsdruck sicher standhalten. Auswölbungen des Gehäuses aufgrund eines hohen Innendrucks werden im Bereich der Verstärkungsanordnung reduziert bzw. vermieden. Dadurch können Scherbelastungen bzw. Schälbelastungen auf die stoffschlüssige Verbindung und/oder die Haftverbindung erheblich reduziert werden.

Bei einer bevorzugten Ausführungsform sind die erste Gehäuseöffnung und die zweite Gehäuseöffnung im Wesentlichen rechteckig. Die Gehäuseöffnungen können auch andere polygonale und/oder runde Formen aufweisen. Bei anderen Ausführungsbeispielen können die Gehäuseöffnungen kreisrund sein. Die beiden Gehäuseöffnungen haben insbesondere eine identische Größe und Form.

Die erste Verbindungsfläche kann unmittelbar an die erste Gehäuseöffnung angrenzen oder durch einen Rand oder Stegbereich davon getrennt sein. Insbesondere ragt die erste Verbindungsfläche nicht über die Wand des Gehäuses in die erste Gehäuseöffnung hinein. Analog hierzu kann die zweite Verbindungsfläche unmittelbar an die zweite Gehäuseöffnung angrenzen oder durch einen Rand oder Stegbereich davon getrennt sein. Insbesondere ragt die zweite Verbindungsfläche nicht in die zweite Gehäuseöffnung hinein.

Die erste Gehäuseöffnung und die zweite Gehäuseöffnung sind bei einer bevorzugten Ausführungsform zumindest abschnittsweise parallel zu einer Ebene ausgerichtet, die durch eine Längsrichtung und eine Querrichtung aufgespannt wird. Eine Höhenrichtung erstreckt sich rechtwinklig zur Längsrichtung und rechtwinklig zur Querrichtung. Die Längsrichtung, die Querrichtung und die Höhenrichtung bilden ein kartesisches Koordinatensystem.

Es ist vorteilhaft, wenn das erste Gehäuseteil auf zwei sich gegenüberliegenden Seiten jeweils einen Verstärkungsvorsprung oder jeweils eine Verstärkungsanordnung aufweist. Das zweite Gehäuseteil kann analog hierzu auf zwei sich gegenüberliegenden Seiten jeweils einen Verstärkungsvorsprung oder jeweils eine Verstärkungsanordnung aufweisen. Die Verstärkungsvorsprünge des ersten Gehäuseteils und die Verstärkungsvorsprünge des zweiten Gehäuseteils können sich jeweils paarweise gegenüberliegen. Die Form und die Größe der Verstärkungsvorsprünge eines gemeinsamen Paares können identisch sein, insbesondere in Querrichtung und in Längsrichtung.

Es ist bevorzugt, wenn jedem Verstärkungsvorsprung des ersten Gehäuseteils ein Verstärkungsvorsprung des zweiten Gehäuseteils gegenüberliegt oder umgekehrt. Dabei kann jedem Verstärkungsvorsprung des ersten Gehäuseteils genau ein Verstärkungsvorsprung des zweiten Gehäuseteils gegenüberliegen. Die sich gegenüberliegenden Verstärkungsvorsprünge sind bevorzugt mittels einer Kopplungseinrichtung miteinander verbunden. Die Kopplungseinrichtung kann beispielsweise lösbar am explosionsgeschützten Gehäuse angebracht werden. Die Kopplungseinrichtung befindet sich außerhalb des ersten Innenraums und außerhalb des zweiten Innenraums.

Mittels der Kopplungseinrichtung kann eine lösbare Verbindung, beispielsweise eine Schraubverbindung, zwischen den sich gegenüberliegenden Verstärkungsvorsprüngen bzw. den einender zugeordneten Verstärkungsanordnungen hergestellt werden. Alternativ zu einer lösbaren Verbindung kann die Verbindung mittels der Kopplungseinrichtung auch eine unlösbare Verbindung sein, beispielsweise eine Nietverbindung.

Jede Kopplungseinrichtung weist wenigstens ein Kopplungselement und vorzugsweise wenigstens zwei Kopplungselemente auf, wie z.B. wenigstens eine Schraube, wenigstens einen Bolzen, wenigstens einen Bügel oder ein anderes geeignetes mechanisches Kopplungselement. Das wenigstens eine Kopplungselement ist bevorzugt ein metallisches Element. Das wenigstens eine Kopplungselement verbindet die sich gegenüberliegende Verstärkungsvorsprünge und insbesondere stellt es eine Verbindung zwischen den Verstärkungselementen an den sich gegenüberliegenden Verstärkungsvorsprüngen her. Hierzu kann das wenigstens eine Kopplungselement an den beiden Verstärkungselementen anliegen und diese insbesondere aufeinander zu drängen, insbesondere ziehen.

Durch die wenigstens eine Kopplungseinrichtung des explosionsgeschützten Gehäuses können die beiden Gehäuseteile sozusagen zusätzlich mechanisch gegeneinander gedrückt werden, was die Last auf die stoffschlüssige Verbindung bzw. Haftverbindung im Falle einer Explosion im Innenraum des Gehäuses reduziert.

Es ist vorteilhaft, wenn jedes metallische Verstärkungselement plattenförmig oder streifenförmig ist. Bei einem Ausführungsbeispiel kann jedes metallische Verstärkungselement ein metallisches Verstärkungsblech sein.

Vorzugsweise ist eine Länge des metallischen Verstärkungselements parallel zur Umfangsrichtung größer als eine Breite rechtwinklig zur Umfangsrichtung. Die Länge des Verstärkungselements kann z.B. mindestens um den Faktor 5 oder mindestens um den Faktor 10 größer sein als die Breite des Verstärkungselements.

Vorzugsweise ist jedes metallische Verstärkungselement lösbar an dem jeweils zugeordneten Verstärkungsvorsprung angeordnet und kann beispielsweise lose an dem jeweiligen Verstärkungsvorsprung anliegen. Bei einer bevorzugten Ausführungsform stützt sich das metallische Verstärkungselement auf einer Gitterstruktur oder einem Gitterprofil des zugeordneten Verstärkungsvorsprungs ab. Eine vollflächige Anlage zwischen dem Verstärkungselement und dem Verstärkungsvorsprung ist möglich, aber nicht notwendig.

Bei einem Ausführungsbeispiel hat die erste Verbindungsfläche und/oder die zweite Verbindungsfläche wenigstens einen in Umfangsrichtung ringförmig geschlossenen Verbindungsvorsprung. Ein solcher Verbindungsvorsprung ist insbesondere dann vorteilhaft, wenn das Material des Verbindungsvorsprungs zum Herstellen einer Schweißverbindung zwischen den beiden Gehäuseteilen verwendet wird. Jeder Verbindungsvorsprung kann beispielsweise eine Schweißnaht, insbesondere Reibschweißnaht zwischen dem ersten Gehäuseteil und dem zweiten Gehäuseteil bilden.

Es ist vorteilhaft, wenn jeder Verstärkungsvorsprung und jedes Verstärkungselement zumindest in einem mittleren Abschnitt entlang der jeweiligen Seite des Gehäuseteils angeordnet ist. Diese Ausgestaltung betrifft insbesondere Gehäuseteile mit im Wesentlichen polygonalen Gehäuseöffnungen. Es ist nicht erforderlich, dass sich der Verstärkungsvorsprung über die gesamte benachbarte Seite des Gehäuseteils erstreckt. Er kann jeweils mit Abstand zu den Eckbereichen angeordnet sein, an denen die Seite des Gehäuseteils in eine andere Seite des Gehäuseteils übergeht.

Jedes Gehäuseteil kann einen oder mehrere Aussteifungsanordnungen aufweisen. Es ist vorteilhaft, wenn jeder Verstärkungsvorsprung und jedes daran angeordnete Verstärkungselement teilweise oder vollständig in Umfangsrichtung entlang einer Aussteifungsanordnung des Gehäuseteils angeordnet ist. Auf diese Weise können sich die Wirkung der Verstärkungsanordnung (Verstärkungsvorsprung mit daran angeordnetem Verstärkungselement) und der Aussteifungsanordnung ergänzen.

Vorzugsweise beträgt eine Länge der Aussteifungsanordnung und/oder des benachbarten Verstärkungsvorsprungs und/oder des Verstärkungselements in Umfangsrichtung mindestens 50% der Länge der jeweiligen Seite des Gehäuseteils in Umfangsrichtung. Durch diese Dimensionierung kann ein Wölben der jeweiligen Seite des Gehäuseteils im Falle einer Explosion im Innenraum besonders effektiv vermieden bzw. reduziert werden.

Bei einem Ausführungsbeispiel weist jede Aussteifungsanordnung mehrere Aussteifungsrippen auf. Die Aussteifungsrippen können insbesondere rechtwinklig oder schräg zu der Ebene ausgerichtet sein, in der sich die betreffende Gehäuseöffnung erstreckt. Insbesondere erstrecken sich die Aussteifungsrippen an der Außenseite des jeweiligen Gehäuseteils vom Flansch weg.

Vorzugsweise hat jeder Flansch einen Steg, der mit Abstand zu dem benachbarten Wandabschnitt des jeweiligen Gehäuseteils angeordnet ist. Zwischen dem Steg und dem Wandabschnitt ist ein Zwischenraum gebildet. Die Aussteifungsrippen können zumindest teilweise in den Zwischenraum hineinragen. Die Aussteifungsrippen können mit dem Steg und dem Wandabschnitt verbunden sein.

Vorteilhafte Ausgestaltungen des explosionsgeschützten Gehäuses ergeben sich aus den abhängigen Patentansprüchen, der Beschreibung und den Zeichnungen. Nachfolgend werden bevorzugte Ausführungsbeispiele des explosionsgeschützten Gehäuses anhand der beigefügten Zeichnungen im Einzelnen erläutert. Es zeigen:
Figur 1 eine perspektivische Darstellung eines Ausführungsbeispiels eines explosionsgeschützten Gehäuses,
Figur 2 einen Längsschnitt durch das Ausführungsbeispiel des explosionsgeschützten Gehäuses aus Figur 1,
Figur 3 eine perspektivische Darstellung eines ersten Gehäuseteils des explosionsgeschützten Gehäuses gemäß der Figuren 1 und 2,
Figur 4 eine perspektivische Darstellung eines zweiten Gehäuseteils des explosionsgeschützten Gehäuses gemäß der Figuren 1 und 2,
Figuren 5 und 6 jeweils eine stark schematisierte Prinzipdarstellung der Wirkung der Verstärkungsanordnungen bei einem erfindungsgemäßen explosionsgeschützten Gehäuse.

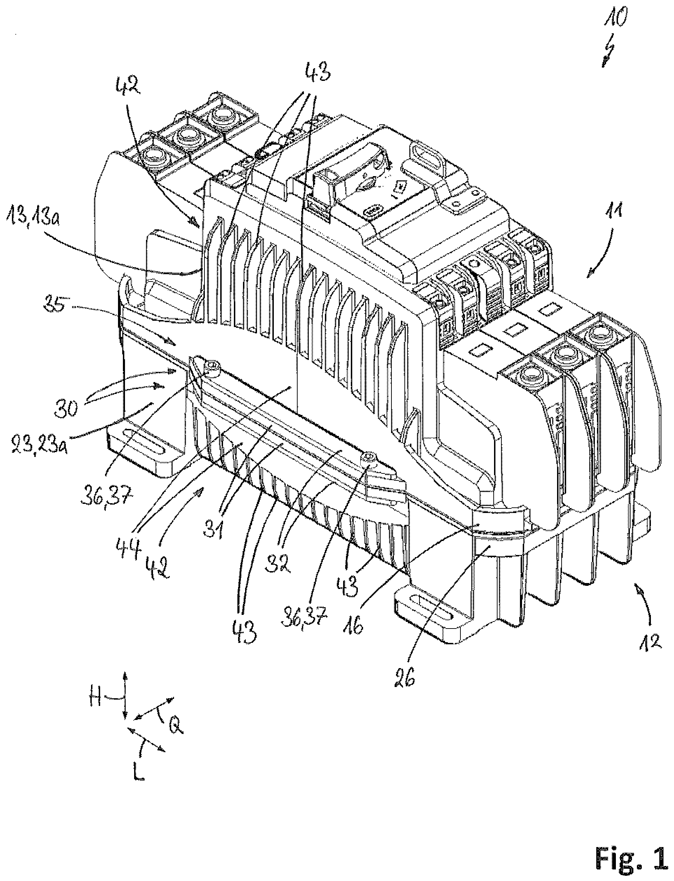

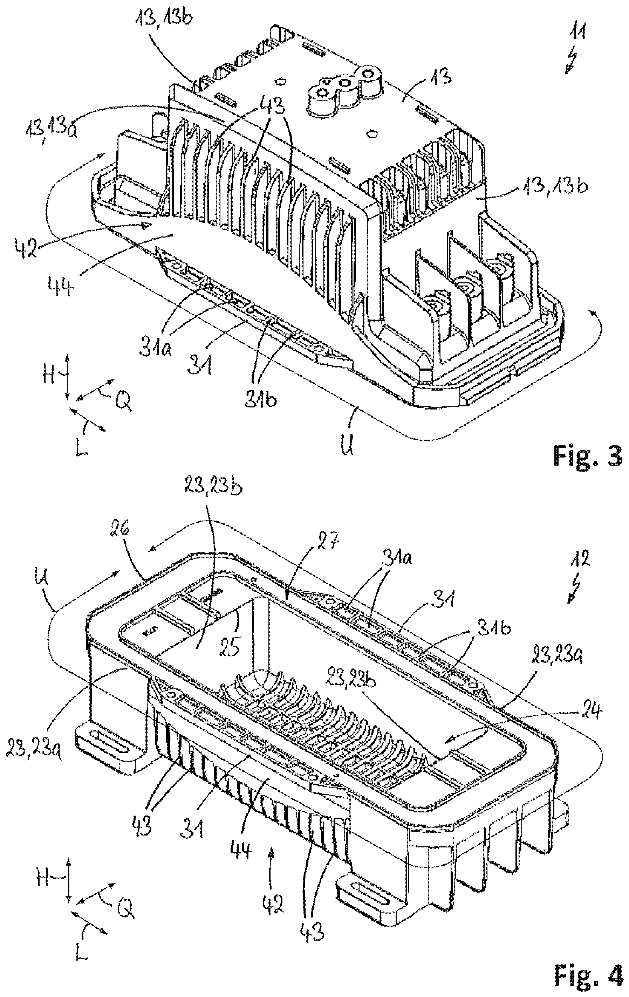

In Figur 1 ist ein Ausführungsbeispiel eines erfindungsgemäßen explosionsgeschützten Gehäuses 10 dargestellt. Das explosionsgeschützte Gehäuse 10 hat ein erstes Gehäuseteil 11 (Figur 3) sowie ein zweites Gehäuseteil 12 (Figur 4). Das erste Gehäuseteil 11 kann als Deckel und das zweite Gehäuseteil 12 kann als Schale bezeichnet werden. Die beiden Gehäuseteile 11, 12 sind stoffschlüssig miteinander verbunden und/oder mittels einer Haftverbindungsschicht miteinander verbunden. Beim Ausführungsbeispiel ist - vorzugsweise ausschließlich - eine stoffschlüssige Verbindung durch Herstellen einer Schweißverbindung, insbesondere einer Reibschweißverbindung hergestellt. Die Verbindung zwischen den beiden Gehäuseteilen 11, 12 kann somit als unlösbare Verbindung bezeichnet werden.

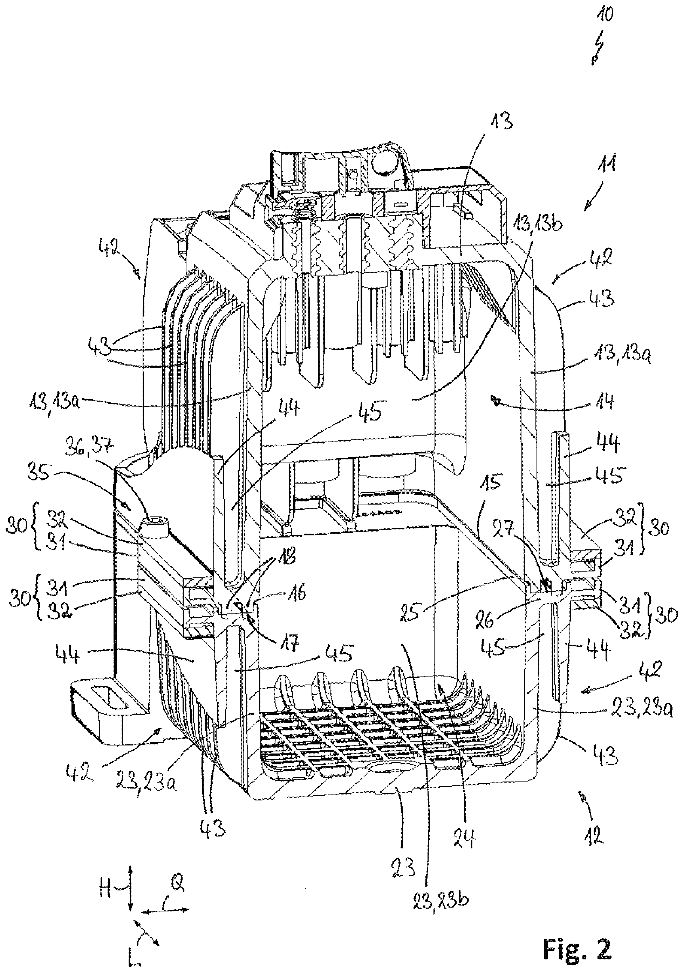

Das erste Gehäuseteil 11 weist mehrere erste Wandabschnitte 13 auf, die einen ersten Innenraum 14 umschließen (siehe insbesondere Figur 2). Der erste Innenraum ist an einer Seite durch eine erste Gehäuseöffnung 15 zugänglich.

Die erste Gehäuseöffnung 15 wird von einem ersten Flansch 16 des ersten Gehäuseteils 11 in einer Umfangsrichtung U um die erste Gehäuseöffnung 15 vollständig ringförmig umschlossen. Die Umfangsrichtung U ist schematisch in Figur 3 veranschaulicht. An dem ersten Flansch 16 ist eine erste Verbindungsfläche 17 vorhanden, die die erste Gehäuseöffnung 15 in Umfangsrichtung U vollständig ringförmig umschließt. Die erste Verbindungsfläche 17 erstreckt sich bei dem hier dargestellten Ausführungsbeispiel abschnittsweise oder vollständig parallel zu einer Ebene, in der sich die Gehäuseöffnung 15 befindet. Diese Ebene ist beispielsgemäß durch eine Längsrichtung L und eine Querrichtung Q aufgespannt. Eine Höhenrichtung H ist rechtwinklig zur Längsrichtung L und zur Querrichtung Q ausgerichtet. Die Längsrichtung L, die Querrichtung Q und die Höhenrichtung H bilden ein kartesisches Koordinatensystem für das explosionsgeschützte Gehäuse 10.

Alternativ zu dem veranschaulichten bevorzugten Ausführungsbeispiel könnte sich die erste Verbindungsfläche 17 zumindest abschnittsweise schräg geneigt zur Höhenrichtung H erstrecken, so dass sich das erste Gehäuseteil 11 ausgehend von der ersten Gehäuseöffnung 15 entlang der ersten Verbindungsfläche 17 nach außen erweitert.

Wie es aus Figur 2 hervorgeht, erstreckt sich die erste Verbindungsfläche 17 beim Ausführungsbeispiel nicht vollständig entlang einer einzigen Ebene, sondern weist wenigstens einen und beispielsgemäß zwei Verbindungsvorsprünge 18 auf. Die erste Verbindungsfläche 17 hat daher eine abgestufte Gestalt. Die Verbindungsvorsprünge 18 erstrecken sich in Umfangsrichtung U vollständig um die erste Gehäuseöffnung 15. Sie dienen beispielsgemäß zur Anlage und zur stoffschlüssigen Verbindung mit dem zweiten Gehäuseteil 12.

Das zweite Gehäuseteil 12 ist im Wesentlichen analog zum ersten Gehäuseteil 11 ausgeführt. Das zweite Gehäuseteil 12 weist mehrere zweite Wandabschnitte 23 auf, die einen zweiten Innenraum 24 umschließen. Der zweite Innenraum 24 ist an einer Seite über eine zweite Gehäuseöffnung 25 zugänglich.

Die zweite Gehäuseöffnung 25 wird in Umfangsrichtung U vollständig ringförmig von einem zweiten Flansch umschlossen, an dem eine zweite Verbindungsfläche 27 vorhanden ist. Die zweite Verbindungsfläche 27 umschließt die zweite Gehäuseöffnung 25 in Umfangsrichtung U vollständig.

Bei dem hier veranschaulichten Ausführungsbeispiel erstreckt sich die zweite Verbindungsfläche 27 abschnittsweise oder vollständig parallel zu einer Ebene, die durch die Längsrichtung L und die Querrichtung Q aufgespannt ist. In Abwandlung hierzu kann die zweite Verbindungsfläche 27 zumindest abschnittsweise auch schräg zur Höhenrichtung H ausgerichtet sein. Die Orientierung der beiden Verbindungsflächen 17, 27 ist aneinander angepasst, so dass sie sich bei hergestellter Verbindung an jeder Stelle in Umfangsrichtung U im Wesentlichen parallel zueinander erstrecken.

Die beiden Gehäuseteile 11, 12 sind nicht metallische Gehäuseteile 11, 12 und bestehen beim Ausführungsbeispiel aus Kunststoff oder einem Verbundmaterial mit Kunststoffmatrix. Der Kunststoff kann in beiden Fällen ein Thermoplast sein.

Über die beiden Verbindungsflächen 17, 27 wird die stoffschlüssige Verbindung und/oder Haftverbindung zwischen den beiden Gehäuseteilen 11, 12 hergestellt. Beispielsweise kann das Material, das durch den wenigstens einen Verbindungsvorsprung 18 bereitgestellt wird, zur Herstellung einer Schweißnaht verwendet werden (Schmelzen und erneutes Aushärten des Materials). Die beiden Gehäuseteile 11, 12 können dabei gegeneinander gedrückt werden, so dass beim Aushärten des aufgeschmolzenen Materials eine stoffschlüssige Verbindung zwischen den beiden Gehäuseteilen 11, 12 entsteht. Jeder Verbindungsvorsprung 18 kann somit eine in Umfangsrichtung U vollständig geschlossene Schweißnaht bilden. Das Schweißen kann beispielsweise durch Reibschweißen, Laserstrahlschweißen, Ultraschallschweißen oder dergleichen erfolgen.

Der erste Innenraum 14 und der zweite Innenraum 24 bilden bei hergestellter Verbindung zwischen den beiden Gehäuseteilen 11, 12 einen Gehäuseinnraum des explosionsgeschützten Gehäuses 10, der eine im Wesentlichen quaderförmige Kontur haben kann. Die äußere und/oder innere Form des explosionsgeschützten Gehäuses 10 bzw. der Gehäuseteile 11, 12 kann variieren.

Die beiden Gehäuseöffnungen 15, 25 sind beispielsgemäß im Wesentlichen rechteckig mit vorzugsweise abgerundeten Eckbereichen. Auch andere polygonale Formen der Gehäuseöffnungen 15, 25 können realisiert werden. Es ist auch möglich, kreisrunde oder elliptische Gehäuseöffnungen 15, 25 zu realisieren, beispielsweise bei im Wesentlichen zylindrischen oder kreiszylindrischen explosionsgeschützten Gehäusen 10.

Jedes Gehäuseteil 11, 12 weist an wenigstens einer Seite eine Verstärkungsanordnung 30 auf. Die Verstärkungsanordnung 30 hat jeweils einen Verstärkungsvorsprung 31 sowie ein daran angeordnetes Verstärkungselement 32 aus Metall oder einer Metalllegierung. Das metallische Verstärkungselement 32 ist beispielsgemäß mechanisch und vorzugsweise lösbar am Verstärkungsvorsprung 31 befestigt, beispielsweise mittels einer Schraubverbindung oder vergleichbaren mechanischen Befestigungselementen. Beispielsgemäß sind die Verstärkungsanordnungen zumindest in einem jeweiligen zentralen Bereich der betreffenden Seite angeordnet.

Das Verstärkungselement 32 kann plattenförmig oder streifenförmig sein. Es kann daher auch als Verstärkungsblech oder Verstärkungsblechstreifen bezeichnet werden. Die Erstreckung des Verstärkungselements 32 in Längsrichtung L ist größer als die Erstreckung in Querrichtung Q und beispielsgemäß mindestens um den Faktor 5 oder mindestens um den Faktor 10 größer. Die Dicke des Verstärkungselements 32 in Höhenrichtung H ist bevorzugt mindestens um den Faktor 3 bis 5 kleiner als die Erstreckung in Querrichtung Q.

In Längsrichtung L hat das explosionsgeschützte Gehäuse 10 eine größere Abmessung als in Querrichtung Q. Die Wandabschnitte 13, 23 der beiden Gehäuseteile 11 bzw. 12, die sich in Querrichtung Q auf entgegengesetzten Seiten des jeweiligen Innenraums 14, 24 gegenüberliegen, können daher auch als Längsseitenwandabschnitte 13a, 23a bezeichnet werden. Die Wandabschnitte 13, 23, die sich in Längsrichtung L auf entgegengesetzten Seiten des jeweiligen Innenraums 14 bzw. 24 gegenüberliegen, können als Querseitenwandabschnitte 13b, 23b bezeichnet werden. Beim Ausführungsbeispiel ist an jedem Längsseitenwandabschnitt 13a, 23a jedes Gehäuseteils 11, 12 eine Verstärkungsanordnung 30 umfassend jeweils einen Verstärkungsvorsprung 31 und jeweils ein Verstärkungselement 32 vorhanden.

In Längsrichtung L kann sich die Verstärkungsanordnung entlang einer Länge erstrecken, die kleiner ist als die Abmessung des ersten Innenraums 14 und des zweiten Innenraums 24 in Längsrichtung L im Bereich der Verbindungsflächen 17, 27. Die Länge jedes Verstärkungsvorsprungs 31 in Längsrichtung L ist größer als seine Breite in Querrichtung Q und beispielsgemäß mindestens um den Faktor 5 oder den Faktor 10 größer.

Bei hergestellter Verbindung zwischen den beiden Gehäuseteilen 11, 12 ist jeder Verstärkungsanordnung 30 des ersten Gehäuseteils 11 jeweils eine und beispielsgemäß genau eine Verstärkungsanordnung 30 des zweiten Gehäuseteils 12 zugeordnet. Dabei liegen sich die Verstärkungsvorsprünge 31 in Höhenrichtung H gegenüber und können optional zumindest stellenweise aneinander anliegen.

Die Verstärkungsanordnungen 30 eines gemeinsamen Paares, die sich in Höhenrichtung H gegenüberliegen, sind beim Ausführungsbeispiel durch eine Kopplungseinrichtung 35 mechanisch miteinander verbunden. Die Verbindung über die Kopplungseinrichtung 35 kann eine lösbare Verbindung sein, beispielsweise eine Schraubverbindung. Alternativ dazu kann es sich auch um eine unlösbare mechanische Verbindung handeln, beispielsweise eine Nietverbindung.

Zur Herstellung der Verbindung weist die Kopplungseinrichtung 35 wenigstens ein Kopplungselement 36 und beispielsgemäß zwei Kopplungselemente 36. Alternativ zu dem dargestellten Ausführungsbeispiel können auch mehr als zwei Kopplungselemente 36 verwendet werden. Das Kopplungselement 36 kann beispielsweise ein Kopplungsbolzen oder ein Kopplungsbügel sein. Beim Ausführungsbeispiel weist das Kopplungselement 36 eine Schraube 37 auf, deren Kopf an einer Verstärkungsanordnung 30 anliegt und deren Mutter (nicht dargestellt) an der jeweils damit verbundenen gegenüberliegenden Verstärkungsanordnung 30 anliegt. Vorzugsweise stützen sich der Kopf und die Mutter dieser Schraubverbindung nicht unmittelbar am jeweiligen Verstärkungsvorsprung 31 ab, sondern liegen unmittelbar oder mittelbar an dem Verstärkungselement 32 an.

Wie es aus den Figuren 1 und 2 hervorgeht, sind die Verstärkungsvorsprünge 31 zweier miteinander verbundener Verstärkungsanordnungen 30 zwischen den beiden metallischen Verstärkungselementen 32 angeordnet. In Höhenrichtung H befinden sich die Verstärkungselemente 32 daher auf entgegengesetzten Seiten, der mittels der Kopplungseinrichtung 35 verbundenen Verstärkungsvorsprünge 31 bzw. Verstärkungsanordnungen 30.

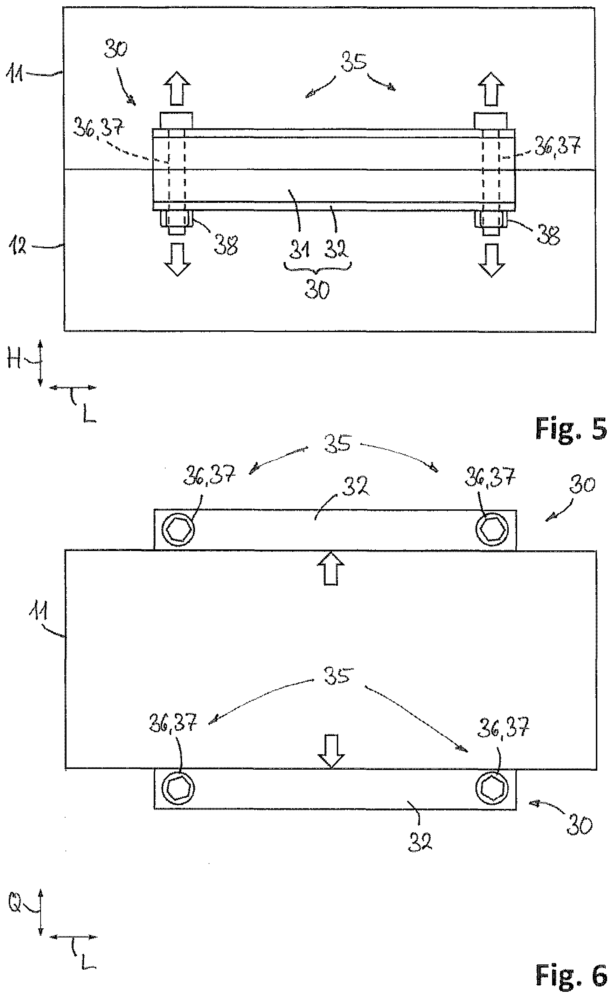

Die Kopplungseinrichtung 35 bzw. das wenigstens eine Kopplungselement 36 kann in Höhenrichtung H Zugkräfte aufnehmen, so dass im Falle einer Explosion im Inneren des explosionsgeschützten Gehäuses 10 die in Höhenrichtung H wirkenden Kräfte, die die beiden Gehäuseteile 11, 12 voneinander weg drängen, nicht vollständig durch die stoffschlüssige Verbindung und/oder Haftverbindung zwischen den Gehäuseteilen 11, 12 aufgenommen werden müssen, sondern zumindest teilweise durch die Kopplungseinrichtung 35 aufgenommen werden (Figur 5).

In Figur 6 ist schematisch dargestellt, dass durch den Explosionsdruck im Inneren des explosionsgeschützten Gehäuses 10 auch Kräfte auf die Längsseitenwandabschnitte 13a, 23a der beiden Gehäuseteile 11, 12 einwirken, die die Längsseitenwandabschnitte 13a, 23a voneinander weg nach außen beaufschlagen und eine Verformung zur Folge haben können. Durch die Verstärkung mittels der Verstärkungsanordnungen 30 werden die Längsseitenwandabschnitte 13a, 23a zusätzlich abgestützt, insbesondere im Bereich der Verbindungsflächen 17, 27. Daher wird einer unerwünschten Verformung entgegengewirkt. Scherbelastungen oder Schälbelastungen auf die stoffschlüssige Verbindung bzw. Haftverbindung zwischen den beiden Gehäuseteilen 11, 12 werden dadurch zumindest verringert.

Um eine unerwünschte Verformung der Längsseitenwandabschnitte in Höhenrichtung H benachbart zur Verstärkungsanordnung 30 zu vermeiden, können die Gehäuseteile 11, 12 optional an jedem Längsseitenwandabschnitt eine Aussteifungsanordnung 42 aufweisen. Die Länge des Bereichs, in dem die Aussteifungsanordnung 42 angeordnet ist, kann im Wesentlichen der Länge der benachbart angeordneten Verstärkungsanordnung 30 entsprechen. Diese Länge kann in Längsrichtung L mindestens 50% der Länge des Längsseitenwandabschnitts des betreffenden Gehäuseteils 11, 12 entsprechen.

Die Aussteifungsanordnung 42 weist mehrere beispielsgemäß parallel zueinander verlaufende Aussteifungsrippen 43 auf. Die Aussteifungsrippen 43 erstrecken sich beispielsgemäß parallel zu einer Ebene, die durch die Höhenrichtung H und die Querrichtung Q aufgespannt ist. Die Aussteifungsrippen 43 verbinden den jeweiligen ersten Flansch 16 des ersten Gehäuseteils 11 bzw. den zweiten Flansch 26 des zweiten Gehäuseteils 12 mit dem daran anschließenden ersten Wandabschnitt 13 oder zweiten Wandabschnitt (vergleiche Figur 2).

Zur weiteren Aussteifung kann der erste Flansch 16 und/oder der zweite Flansch 26 optional und wie beim veranschaulichten Ausführungsbeispiel einen Steg 44 aufweisen. Der Steg 44 erstreckt sich mit Abstand zum benachbarten ersten Wandabschnitt 13 bzw. zweiten Wandabschnitt 23 und beim Ausführungsbeispiel benachbart zum jeweiligen Längsseitenwandabschnitt 13a, 23a des betreffenden Gehäuseteils 11 bzw. 12. Zwischen dem Steg 44 und dem benachbarten Wandabschnitt 13 bzw. 23 ist ein Zwischenraum 45 gebildet. Die Aussteifungsrippen 43 oder zumindest ein Teil der vorhandenen Aussteifungsrippen 43 ragt in den Zwischenraum 45 hinein. Beim Ausführungsbeispiel weist jede Aussteifungsrippe 43 bzw. zumindest die Mehrheit der vorhandenen Aussteifungsrippen 43 einen Abschnitt auf, der sich innerhalb des Zwischenraums 45 erstreckt und sich unmittelbar an den jeweiligen Flansch 16 bzw. 26 anschließt. In dem Zwischenraum 45 stellen die Aussteifungsrippen 43 eine Verbindung zwischen dem Steg 44 und dem gegenüberliegenden ersten Wandabschnitt 13 bzw. zweiten Wandabschnitt 23 her (Figur 2).

Die wenigstens eine Aussteifungsanordnung 42, der wenigstens eine Steg 44 und der wenigstens eine Verstärkungsvorsprung 31 sind beim Ausführungsbeispiel monolithischer Bestandteil des betreffenden ersten Gehäuseteils 11 bzw. zweiten Gehäuseteils 12. Das erste Gehäuseteil 11 bzw. zweite Gehäuseteil 12 kann durch ein Gussverfahren hergestellt werden, beispielsweise ein Spritzgussverfahren.

Wie es in den Figuren 2-4 zu erkennen ist, kann jeder Verstärkungsvorsprung 31 mehrere Hohlräume oder Kammern aufweisen. Diese Hohlräume oder Kammern können in Höhenrichtung H nach oben und/oder nach unten offen sein. Zur Trennung der einzelnen Kammern 31a voneinander kann jeder Verstärkungsvorsprung 31 Trennstege 31b aufweisen, die sich beim Ausführungsbeispiel rechtwinklig zur Längsrichtung L erstrecken. An diesen Trennstegen 31b kann das am Verstärkungsvorsprung 31 angebrachte Verstärkungselement 32 anliegen.

Das Anbringen eines jeweiligen Verstärkungselements 32 am Verstärkungsvorsprung 31 erfolgt beispielsgemäß durch die Herstellung der Verbindung zwischen zwei aneinander zugeordneten Verstärkungsanordnungen 30 mittels der Kopplungseinrichtung 35.

Beim Ausführungsbeispiel ist das explosionsgeschützte Gehäuse in der Zündschutzart "druckfeste Kapselung (Ex d)" ausgeführt. Die stoffschlüssige Verbindung bzw. Haftverbindung an den Verbindungsflächen 17, 27 zwischen den beiden Gehäuseteilen 11, 12 ist vorzugsweise fluiddicht und insbesondere gasdicht. Zumindest eines der Gehäuseteile 11, 12 kann zünddurchschlagsichere Spalte aufweisen, über die ein Gasaustausch zwischen dem Inneren des explosionsgeschützten Gehäuses 10 (gebildet durch den ersten Innenraum 14 und den zweiten Innenraum 24) und der Umgebung um das Gehäuse 10 herum möglich ist. Daher können zündfähige Gase in den Innenraum des explosionsgeschützten Gehäuses 10 gelangen und dort eine Explosion auslösen. Aufgrund der beschriebenen Ausführung des explosionsgeschützten Gehäuses 10 mit den eine Verstärkungsanordnung 30 aufweisenden Gehäuseteilen 11, 12 hält das explosionsgeschützte Gehäuse 10 dem Explosionsdruck stand. Auch unter Berücksichtigung von Herstellungstoleranzen werden die Vorschriften der betreffenden Norm erfüllt und dennoch lässt sich das explosionsgeschützte Gehäuse 10 mit geringem Materialaufwand auf einfache Weise herstellen.

Die Erfindung betrifft ein explosionsgeschützte Gehäuse 10 mit einem nicht metallischen ersten Gehäuseteil 11 und einem nicht metallischen zweiten Gehäuseteil 12, die an einer Verbindungsstelle stoffschlüssig miteinander verbunden sind, um ein Innenvolumen des explosionsgeschützten Gehäuses 10 gegenüber einer explosionsgefährdeten Atmosphäre explosionsgeschützt bzw. zünddurchschlagsicher zu umschließen. Jedes Gehäuseteil 11, 12 weist wenigstens eine Verstärkungsanordnung 30 auf, die im Bereich der Verbindungsstelle zwischen den beiden Gehäuseteilen 11, 12 angeordnet ist. Zu jeder Verstärkungsanordnung 30 gehört ein Verstärkungsvorsprung 31 und ein metallisches Verstärkungselement 32. Vorzugsweise liegen sich bei hergestellter Verbindung zwischen den Gehäuseteilen 11, 12 jeweils eine Verstärkungsanordnung 30 des ersten Gehäuseteils 11 und eine Verstärkungsanordnung 30 des zweiten Gehäuseteils 12 gegenüber. Diese beiden gegenüberliegenden Verstärkungsanordnungen 30 können optional zusätzlich mit wenigstens einem vorzugsweise metallischen Kopplungselement 36 miteinander verbunden sein.

### Bezugszeichenliste:

- 10: explosionsgeschütztes Gehäuse
- 11: erstes Gehäuseteil
- 12: zweites Gehäuseteil
- 13: erster Wandabschnitt
- 13a: Längsseitenwandabschnitt des ersten Gehäuseteils
- 13b: Querseitenwandabschnitt des ersten Gehäuseteils
- 14: ersten Innenraum
- 15: erste Gehäuseöffnung
- 16: erster Flansch
- 17: erste Verbindungsfläche
- 18: Verbindungsvorsprung

- 23: zweiter Wandabschnitt
- 23a: Längsseitenwandabschnitt des zweiten Gehäuseteils
- 23b: Querseitenwandabschnitt des zweiten Gehäuseteils
- 24: zweite Innenraum
- 25: zweite Gehäuseöffnung
- 26: zweiten Flansch
- 27: zweite Verbindungsfläche

- 30: Verstärkungsanordnung
- 31: Verstärkungsvorsprung
- 31a: Kammer
- 31b: Trennsteg
- 32: Verstärkungselement

- 35: Kopplungseinrichtung
- 36: Kopplungselement
- 37: Schraube
- 38: Mutter
- 42: Aussteifungsanordnung
- 43: Aussteifungsrippe
- 44: Steg
- 45: Zwischenraum

- H: Höhenrichtung
- L: Längsrichtung
- Q: Querrichtung
- U: Umfangsrichtung

## Patentansprüche

1. Explosionsgeschütztes Gehäuse (10) aufweisend:
ein nicht metallisches erstes Gehäuseteil (11), das einen ersten Innenraum (14) umgibt, der über eine erste Gehäuseöffnung (15) zugänglich ist, wobei die erste Gehäuseöffnung (15) von einem ersten Flansch (16) in einer Umfangsrichtung (U) vollständig umschlossen ist, der eine die erste Gehäuseöffnung (15) vollständig umschließende erste Verbindungsfläche (17) aufweist,
ein nicht metallisches zweites Gehäuseteil (12), das einen zweiten Innenraum (24) umgibt, der über eine zweite Gehäuseöffnung (25) zugänglich ist, wobei die zweite Gehäuseöffnung (25) von einem zweiten Flansch (26) in der Umfangsrichtung (U) vollständig umschlossen ist, der eine die zweite Gehäuseöffnung (25) vollständig umschließende zweite Verbindungsfläche (27) aufweist,
wobei das erste Gehäuseteil (11) und das zweite Gehäuseteil (12) an den sich gegenüberliegenden Verbindungsflächen (17, 27) stoffschlüssig und/oder durch eine Haftvermittlung miteinander verbunden sind,
**dadurch gekennzeichnet, dass** das erste Gehäuseteil (11) benachbart zur ersten Verbindungsfläche (17) außerhalb des ersten Innenraums (14) und das zweite Gehäuseteil (12) benachbart zur zweiten Verbindungsfläche (27) außerhalb des zweiten Innenraums (24) jeweils wenigstens einen Verstärkungsvorsprung (31) mit jeweils einem daran angebrachten metallischen Verstärkungselement (32) aufweisen.

2. Explosionsgeschütztes Gehäuse nach Anspruch 1, wobei das erste Gehäuseteil (11) auf zwei sich gegenüberliegenden Seiten jeweils einen Verstärkungsvorsprung (31) aufweist und wobei das zweite Gehäuseteil (12) auf zwei sich gegenüberliegenden Seiten jeweils einen Verstärkungsvorsprung (31) aufweist.

3. Explosionsgeschütztes Gehäuse nach Anspruch 1 oder 2, wobei jedem Verstärkungsvorsprung (31) des ersten Gehäuseteils (11) ein Verstärkungsvorsprung (31) des zweiten Gehäuseteils (12) gegenüberliegt, die mittels einer Kopplungseinrichtung (35) verbunden sind.

4. Explosionsgeschütztes Gehäuse nach Anspruch 3, wobei mittels der Kopplungseinrichtung (35) eine lösbare Verbindung, insbesondere Schraubverbindung, zwischen den sich gegenüberliegenden Verstärkungsvorsprüngen (31) hergestellt ist.

5. Explosionsgeschütztes Gehäuse nach Anspruch 3 oder 4, wobei die Kopplungseinrichtung (35) wenigstens ein Kopplungselement (36), insbesondere eine Schraube (37), aufweist, das die sich gegenüberliegenden Verstärkungsvorsprünge (31) und/oder Verstärkungselemente (32) verbindet.

6. Explosionsgeschütztes Gehäuse nach einem der vorhergehenden Ansprüche, wobei jedes metallische Verstärkungselement (32) plattenförmig oder streifenförmig ist.

7. Explosionsgeschütztes Gehäuse nach einem der vorhergehenden Ansprüche, wobei jedes metallische Verstärkungselement (32) ein metallisches Verstärkungsblech ist.

8. Explosionsgeschütztes Gehäuse nach einem der vorhergehenden Ansprüche, wobei jedes metallische Verstärkungselement (32) lösbar an dem jeweils zugeordneten Verstärkungsvorsprung (31) angeordnet ist.

9. Explosionsgeschütztes Gehäuse nach einem der vorhergehenden Ansprüche, wobei die erste Verbindungsfläche (17) und/oder die zweite Verbindungsfläche (27) wenigstens einen in Umfangsrichtung (U) ringförmig geschlossenen Verbindungsvorsprung (18) aufweist bzw. aufweisen.

10. Explosionsgeschütztes Gehäuse nach einem der vorhergehenden Ansprüche, wobei jeder Verstärkungsvorsprung (31) und jedes Verstärkungselement (32) zumindest in einem mittleren Abschnitt entlang der jeweiligen Seite des Gehäuseteils (11, 12) angeordnet ist.

11. Explosionsgeschütztes Gehäuse nach einem der vorhergehenden Ansprüche, wobei jeder Verstärkungsvorsprung (31) und jedes Verstärkungselement (32) in Umfangsrichtung (U) teilweise oder vollständig entlang einer Aussteifungsanordnung (42) des jeweiligen Gehäuseteils (11, 12) angeordnet ist.

12. Explosionsgeschütztes Gehäuse nach Anspruch 11, wobei eine Länge der Aussteifungsanordnung (42) und/oder des benachbarten Verstärkungsvorsprungs (31) und/oder des Verstärkungselements (32) in Umfangsrichtung (U) mindestens 50% der Länge der jeweiligen Seite des Gehäuseteils (11, 12) in Umfangsrichtung (U) beträgt.

13. Explosionsgeschütztes Gehäuse nach Anspruch 11 oder 12, wobei jede Aussteifungsanordnung (42) mehrere Aussteifungsrippen (43) aufweist, die jeweiligen ersten Flansch (16) oder zweiten Flansch (26) mit einem sich anschließenden Wandabschnitt (13, 23) des jeweiligen Gehäuseteils (11, 12) verbinden.

14. Explosionsgeschütztes Gehäuse nach Anspruch 13, wobei jeder Flansch (16, 26) einen Steg (44) aufweist, der sich unter Bildung eines Zwischenraums (45) mit Abstand zu dem Wandabschnitt (13, 23) des jeweiligen Gehäuseteils (11, 12) erstreckt, wobei die Aussteifungsrippen (43) im Zwischenraum (45) eine Verbindung zwischen dem Steg (44) und dem Wandabschnitt (13, 23) herstellen.

## Claims

1. Explosion-proof housing (10) comprising:
a non-metallic first housing part (11) surrounding a first interior (14) accessible via a first housing opening (15), wherein the first housing opening (15) is completely surrounded in a circumferential direction (U) by a first flange (16) that comprises a first connection surface (17) completely surrounding the first housing opening (15),
a non-metallic second housing part (12) surrounding a second interior (24) accessible via a second housing opening (25), wherein the second housing opening (25) is completely surrounded in circumferential direction (U) by a second flange (26) that comprises a second connection surface (27) completely surrounding the second housing opening (25),
wherein the first housing part (11) and the second housing part (12) are connected to one another at the facing connection surfaces (17, 27) in a substance bond manner and/or by means of adhesion,
**characterized in that** the first housing part (11) adjacent to the first connection surface (17) outside the first interior (14) and the second housing part (12) adjacent to the second connection surface (27) outside the second interior (24) respectively comprise at least one reinforcement projection (31) having a metallic reinforcement element (32) attached thereon respectively.

2. Explosion-proof housing according to claim 1, wherein
the first housing part (11) comprises one reinforcement projection (31) respectively on two opposite sides and wherein the second housing part (12) comprises one reinforcement projection (31) respectively on two opposite sides.

3. Explosion-proof housing according to claim 1 or 2,
wherein one reinforcement projection (31) of the second housing part (12) is arranged opposite to each reinforcement projection (31) of the first housing part (11), which are connected by means of a coupling device (35).

4. Explosion-proof housing according to claim 3, wherein a releasable connection, particularly screw connection, is established between the reinforcement projections (31) arranged opposite one another by means of the coupling device (35).

5. Explosion-proof housing according to claim 3 or 4,
wherein the coupling device (35) comprises at least one coupling element (36), particularly a screw (37), which connects the reinforcement projections (31) and/or reinforcement elements (32) arranged opposite one another.

6. Explosion-proof housing according to any of the preceding claims, wherein each metallic reinforcement element (32) is plate-shaped or strip-shaped.

7. Explosion-proof housing according to any of the preceding claims, wherein each metallic reinforcement element (32) is a metallic reinforcement sheet material.

8. Explosion-proof housing according to any of the preceding claims, wherein each metallic reinforcement element (32) is releasably arranged on the respective assigned reinforcement projection (31).

9. Explosion-proof housing according to any of the preceding claims, wherein the first connection surface (17) and/or the second connection surface (27) comprises or comprise at least one connection projection (18), which is closed in circumferential direction (U) in a ringshaped manner.

10. Explosion-proof housing according to any of the preceding claims, wherein each reinforcement projection (31) and each reinforcement element (32) are arranged at least in a center section along the respective side of the housing part (11, 12).

11. Explosion-proof housing according to any of the preceding claims, wherein each reinforcement projection (31) and each reinforcement element (32) is arranged in circumferential direction (U) partly or entirely along a stiffening assembly (42) of the respective housing part (11, 12).

12. Explosion-proof housing according to claim 11, wherein a length of the stiffening assembly (42) and/or the adjacent reinforcement projection (31) and/or the reinforcement element (32) in circumferential direction (U) is minimum 50% of the length of the respective side of the housing part (11, 12) in circumferential direction (U).

13. Explosion-proof housing according to claim 11 or 12,
wherein each stiffening assembly (42) comprises multiple stiffening ribs (43) that connect the respective first flange (16) or second flange (26) with an adjoining wall section (13, 23) of the respective housing part (11, 12).

14. Explosion-proof housing according to claim 13, wherein each flange (16, 26) comprises a web (44) that extends under formation of an interstice (45) with distance to the wall section (13, 23) of the respective housing part (11, 12), wherein the stiffening ribs (43) establish a connection between the web (44) and the wall section (13, 23) inside the interstice (45).

## Revendications

1. Boîtier antidéflagrant (10) comprenant :
une première partie de boîtier (11) non métallique qui entoure un premier espace intérieur (14), lequel est accessible via une première ouverture de boîtier (15), la première ouverture de boîtier (15) étant entourée complètement, dans une direction périphérique (U), par une première bride (16) qui présente une première surface de liaison (17) entourant complètement la première ouverture de boîtier (15),
une deuxième partie de boîtier (12) non métallique qui entoure un deuxième espace intérieur (24), lequel est accessible via une deuxième ouverture de boîtier (25), la deuxième ouverture de boîtier (25) étant entourée complètement, dans la direction périphérique (U), par une deuxième bride (26) qui présente une deuxième surface de liaison (27) entourant complètement la deuxième ouverture de boîtier (25),
la première partie de boîtier (11) et la deuxième partie de boîtier (12) étant reliées l'une à l'autre sur les surfaces de liaison (17, 27) situées en vis-à-vis l'une de l'autre, par matière et/ou par adhérence,
**caractérisé en ce que** la première partie de boîtier (11) présente, à proximité de la première surface de liaison (17), à l'extérieur du premier espace intérieur (14), et la deuxième partie de boîtier (12) présente, à proximité de la deuxième surface de liaison (27), à l'extérieur du deuxième espace intérieur (24), respectivement au moins une saillie de renforcement (31) dotées chacune d'un élément de renforcement (32) métallique qui y est fixé.

2. Boîtier antidéflagrant selon la revendication 1, dans lequel la première partie de boîtier (11) présente, sur deux côtés situés en vis-à-vis l'un de l'autre, respectivement une saillie de renforcement (31), et dans lequel la deuxième partie de boîtier (12), présente, sur deux côtés situés en vis-à-vis l'un de l'autre, respectivement une saillie de renforcement (31).

3. Boîtier antidéflagrant selon la revendication 1 ou 2, dans lequel une saillie de renforcement (31) de la deuxième partie de boîtier (12) est située en regard de chaque saillie de renforcement (31) de la première partie de boîtier (11), lesquelles saillies sont reliées à l'aide d'un dispositif d'accouplement (35).

4. Boîtier antidéflagrant selon la revendication 3, dans lequel une liaison amovible, en particulier une liaison à vis, est réalisée au moyen du dispositif d'accouplement (35) entre les saillies de renforcement (31) situées en regard l'une de l'autre.

5. Boîtier antidéflagrant selon la revendication 3 ou 4, dans lequel le dispositif d'accouplement (35) présente au moins un élément d'accouplement (36), en particulier une vis (37), qui relie les saillies de renforcement (31) et/ou les éléments de renforcement (32) situés en regard les uns des autres.

6. Boîtier antidéflagrant selon une des revendications précédentes, dans lequel chaque élément de renforcement (32) métallique se présente sous forme de plaque ou sous forme de bande.

7. Boîtier antidéflagrant selon une des revendications précédentes, dans lequel chaque élément de renforcement (32) métallique se présente sous la forme d'une tôle de renforcement métallique.

8. Boîtier antidéflagrant selon une des revendications précédentes, dans lequel chaque élément de renforcement (32) métallique est disposé de façon amovible sur la saillie de renforcement (31) respective associée.

9. Boîtier antidéflagrant selon une des revendications précédentes, dans lequel la première surface de liaison (17) et/ou la deuxième surface de liaison (27) présente(nt) au moins une saillie de liaison (18) fermée sous une forme annulaire dans la direction périphérique (U).

10. Boîtier antidéflagrant selon une des revendications précédentes, dans lequel chaque saillie de renforcement (31) et chaque élément de renforcement (32) est disposé(e) au moins dans une partie centrale le long du côté respectif de la partie de boîtier (11, 12).

11. Boîtier antidéflagrant selon une des revendications précédentes, dans lequel chaque saillie de renforcement (31) et chaque élément de renforcement (32) est disposé(e), dans la direction périphérique (U), en partie ou entièrement le long d'une structure de raidissement (42) de la partie de boîtier (11, 12) respective.

12. Boîtier antidéflagrant selon la revendication 11, dans lequel une longueur de la structure de raidissement (42) et/ou de la saillie de renforcement (31) adjacente et/ou de l'élément de renforcement (32) équivaut, dans la direction périphérique (U), à au moins 50 % de la longueur du côté respectif de la partie de boîtier (11, 12) dans la direction périphérique (U).

13. Boîtier antidéflagrant selon la revendication 11 ou 12, dans lequel chaque structure de raidissement (42) présente plusieurs nervures de raidissement (43) qui relient la première bride (16) ou la deuxième bride (26) respective à une portion de paroi (13, 23) contiguë de la partie de boîtier (11, 12) respective.

14. Boîtier antidéflagrant selon la revendication 13, dans lequel chaque bride (16, 26) présente une aile (44) qui s'étend à distance de la portion de paroi (13, 23) de la partie de boîtier (11, 12) respective, en formant un espace intermédiaire (45), les nervures de raidissement (43) établissant, dans l'espace intermédiaire (45), une liaison entre l'aile (44) et la portion de paroi (13, 23).
